Europäisches Patentamt

(19) European Patent Office

Office européen des brevets

(11) EP 0 921 404 A2

(12) EUROPEAN PATENT APPLICATION

(43) Date of publication:
09.06.1999 Bulletin 1999/23

(51) Int. Cl.$^6$: G01R 27/26

(21) Application number: 98121710.2

(22) Date of filing: 13.11.1998

(84) Designated Contracting States:
AT BE CH CY DE DK ES FI FR GB GR IE IT LI LU MC NL PT SE
Designated Extension States:
AL LT LV MK RO SI

(30) Priority: 04.12.1997 JP 34874597

(71) Applicants:
• Advanced Space Communications Research Laboratory
Chiyoda-ku, Tokyo 101-0032 (JP)
• Eight Kogyo K.K.
Yokohama-shi, Kanagawa 223-0032 (JP)

(72) Inventors:
• Ishida, Hitoshi
Advanced Space Communication
Chioda-ku, Tokyo 101-0032 (JP)

• Kawakami, Yoichi
Advanced Space Communications
Chioda-ku, Tokyo 101-0032 (JP)
• Takahashi, Hironori
Hamamatu Photonics K.K.
Hamamatsu-shi, Shizuoka 435-0051 (JP)
• Sekimoto, Toshikazu
Eight Kogyo K.K.
Yokohama-shi, Kanagawa 223-0052 (JP)

(74) Representative:
Leson, Thomas Johannes Alois, Dipl.-Ing. et al
Patentanwälte
Tiedtke-Bühling-Kinne & Partner,
Bavariaring 4
80336 München (DE)

(54) **High frequency characteristics measurement method for dielectric materials and high frequency circuit design method**

(57) The purpose of this invention is to provide with a method for continuous and accurate measurement of the effective dielectric constant and the dielectric loss of a dielectric material at the same condition as it is implemented in actual circuits. Another purpose of this invention is to improve the high frequency circuit design accuracy by providing with a design method using the actual wavelength-shortening ratio of the circuit that is obtained through the measurement of circuit impedance at the same condition as the circuit is practically used.

The high frequency measurement method for dielectric materials of this invention is characterized as; it measures amplitude and phase variations of the electric field component of an electromagnetic wave along its propagation direction on a high frequency transmission line which is actually implemented as a microstrip line, by using a device whose refraction index changes according to the electric field (or an E-O prober using Pockels Effect), in order to get effective dielectric constant and dielectric loss of said transmission line.

The high frequency circuit design method of this invention is characterized as; phase variation rate of the electric field component of an electromagnetic wave along its propagation direction on a high frequency transmission line which is actually implemented as a microstrip line is measured by using a device whose refraction index changes according to the electric field (or an E-O prober using Pockels Effect), said phase variation rate is used to derive the wavelength-shortening ratio of said transmission line and said wavelength-shortening ratio is used for the high frequency circuit design.

FIG.1

$$\triangle t = t_1 - t_0$$
$$\triangle \phi = 2\pi \triangle t / T$$
$$\beta = -\triangle \phi / \triangle l$$

EP 0 921 404 A2

## Description

### *BACKGROUND OF THE INVENTION*

This invention describes an effective measurement method of the high frequency characteristics of dielectric materials which are used for high frequency filters, isolators or couplers having microstrip line structures, or for high frequency capacitors. This invention also especially describes an efficient measurement method of the effective dielectric constant and the dielectric loss of dielectric materials, and a high frequency circuit board design method which uses the said measurement method.

### *DESCRIPTION OF THE PRIOR ART*

The propagation velocity and the attenuation of the electromagnetic wave propagating in a dielectric material can be derived as follow, respectively, by using the effective dielectric constant and the loss tangent.

$$\text{Propagation Velocity: } V = C / \sqrt{\varepsilon_r},$$

$$\text{Attenuation: } a = f \times \sqrt{\varepsilon_r} \times \tan \delta,$$

where C : light velocity, $\varepsilon_r$: effective dielectric constant, f: frequency, and $\tan \delta$ : loss tangent.

In development, evaluation or design of a high frequency circuit board, a measurement method of high frequency characteristics of the dielectric material, above all a measurement method of the effective dielectric constant and the dielectric loss is important, especially when the dielectric material is the component of a microstrip line.

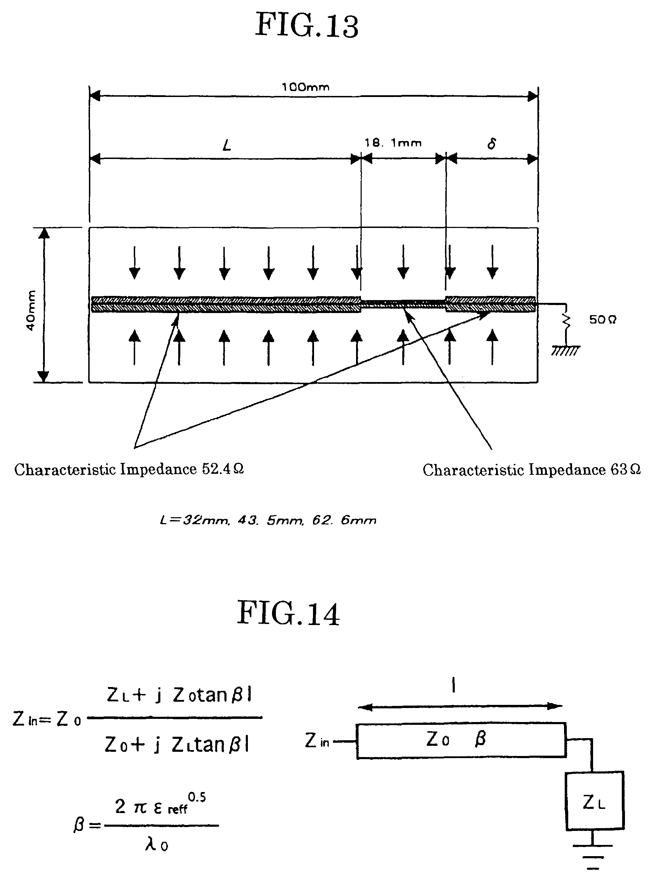

An impedance conversion formulae for a microstrip line (which is a distributed constant line) can be expressed as the following, just as Fig. 14 shows.

$$Z_{in} = Z_0(Z_L + jZ_0 \tan \beta l)/(Z_0 + jZ_L \tan \beta l),$$

where $\beta = 2\pi\varepsilon_{reff}^{0.5}/\lambda_0$, $Z_0$; the characteristic impedance of the line, $Z_L$; the terminating impedance, $\beta$; the phase constant (the number of waves), $\varepsilon_{reff}$; the effective dielectric constant. As the above equation shows, the impedance conversion formula for a microstrip line is determined by the effective dielectric constant($\varepsilon_{reff}$) and the line length.

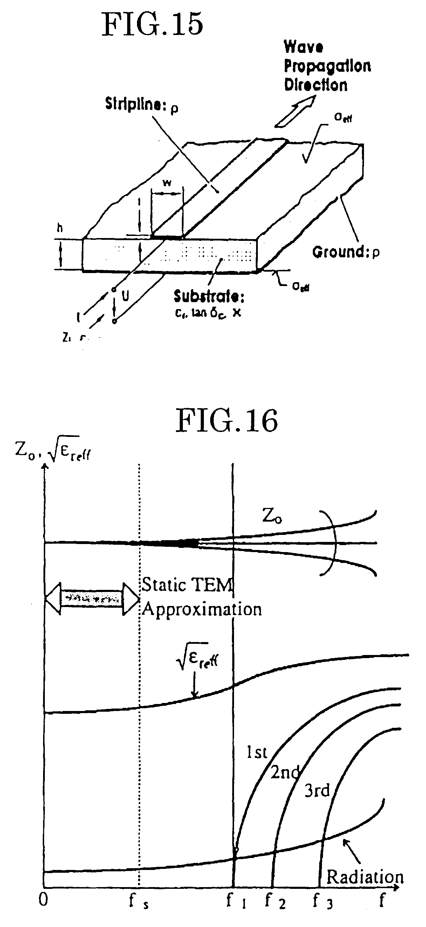

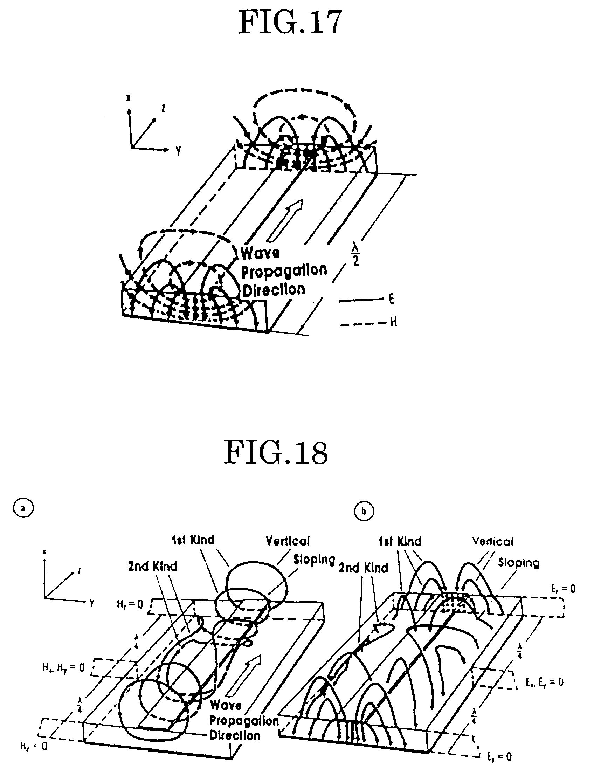

In a microstrip line as shown in Fig. 15, however, the theoretical analysis of the line characteristics becomes extremely difficult, since the strip line is fabricated on the boundary between an dielectric substrate and the free air over the substrate, which causes a complex transmission waveform as a result of this in-homogeneity. Figures 16 to 18 show examples of such theoretical analyses. Figure 17 shows waveforms at a low frequency, Fig. 18 shows waveforms at a high frequency, and Fig. 16 describes the frequency dependant characteristics of the effective dielectric constant derived through a theoretical analysis ("Handbook of Microwave Circuits", Reinmut K. Hoffmann, ARTECH HOUSE, INC.).

In conventional design methods for high frequency circuits, the effective dielectric constant (the wavelength-shortening ratio), which is given by the following equation (approximation), is usually used.

$$\varepsilon_{reff}^{0.5} = \varepsilon e^{0.5} + (\varepsilon_r^{0.5} - \varepsilon_r^{0.5})/(1 + 4F^{-1.5}),$$

$$F = 4h(\varepsilon_r-1)^{0.5}[0.5+\{1 + 2\log(1 + W/h)\}^2]/\lambda_0,$$

$$\text{and } \varepsilon_e = (\varepsilon_r + 1)/2 + (\varepsilon_r - 1)/\{2(1 + 10h/W)^{0.5})\},$$

where $\varepsilon_{reff}$: effective dielectric constant at the transmission line, h thickness of the substrate, W : width of the transmission line, $\lambda_0$ : signal wavelength in the vacuum, $\varepsilon_e$ : effective permittivity of the dielectric material, and $\varepsilon_r$ : dielectric constant of the dielectric material. When a dielectric substrate is selected for the circuit design, the wavelength-shortening ratio can be uniquely determined by the above equations, since the substrate width, the pattern width of the line and the dielectric constant are determined by the design.

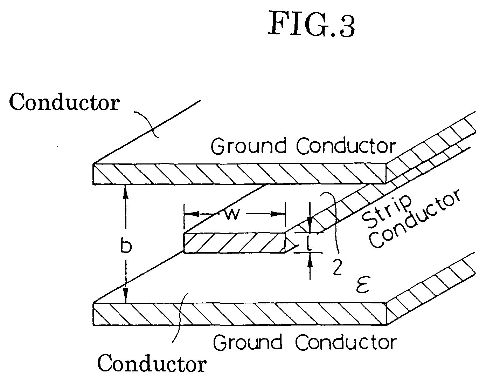

There are two conventional methods for measuring permittivity of dielectric materials, namely, the capacitance method using an LCR meter and the resonance method using a network analyzer. As the capacitance method cannot be applied above 30MHz, the resonance method is used for the higher frequency characteristics measurement as described formerly. In the resonance method, a transmission line 2 is placed between the dielectric body and the high frequency characteristics (resonance characteristics) of the line are measured. Figure 3 shows a cross section view of a tri-plate microstrip line which is used for this measurement method (although dielectric bodies are not shown in Fig.

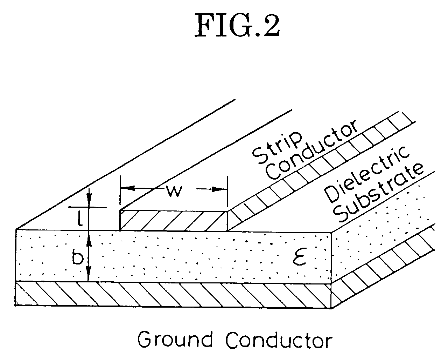

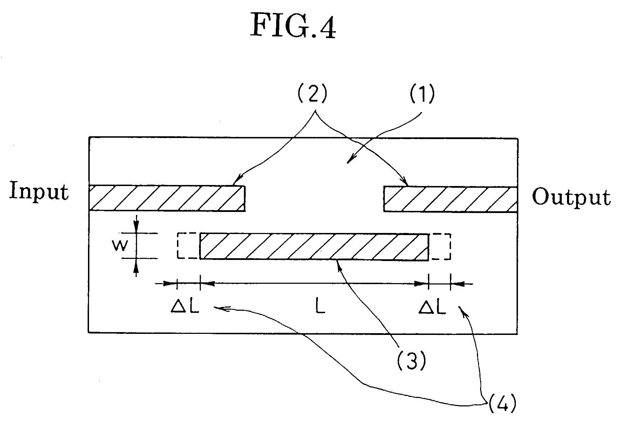

3, a dielectric body actually exists between the upper and lower metals for the ground and the conductor line 2). Figure 4 is a bird's-eye view of the structure depicted in Figure 3, showing the structure of a tri-plate microstrip line resonator. In Figure 4,2 denotes transmission lines having an input port and an output port at each one end, and 3 shows a microstrip line which composes a resonator. Also in Fig. 4, L is the length of the resonator, $\Delta L$ is the electrical correction length and W denotes the width of the microstrip line.

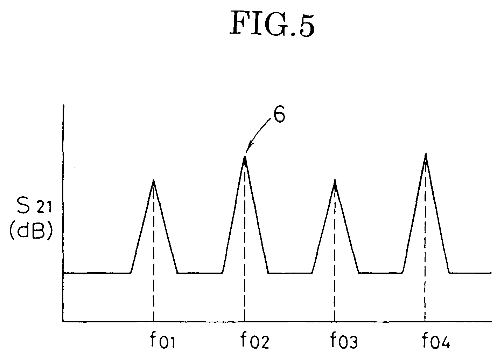

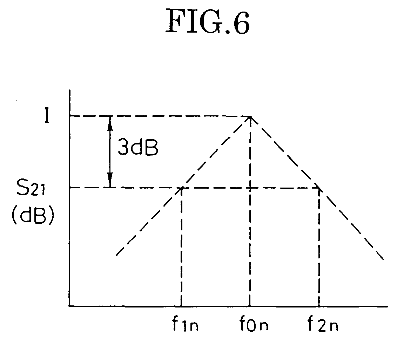

When the S-parameter $S_{12}$ or $S_{21}$ of a tri-plate microstrip line resonator as shown in Fig. 3 is measured by a network analyzer, such traces as are shown in Fig. 5 and Fig.6 are obtained, enabling to read out resonance frequencies $F_{01} \sim F_{o4} \sim$ (see 6 of Fig. 5, for example).

(1) Dielectric constant of the dielectric body ($\varepsilon_r$) is obtained by the following equation.

$$\varepsilon_r = nC / \{2 f_{0n}(L + 2 \Delta L)\},$$

where C : light velocity, $f_{0n}$ : resonance frequency, L : length of the resonator, and $\Delta L$ : electrical correction length.

(2) Also, dielectric loss (or loss tangent) of the dielectric body is given by

$$\tan \delta = 1/Q_u - 1/Q_c,$$

where $Q_u = \{f_{0n}/(f_{2n} - f_{1n})\} \times \{10^{1/20}/(10^{1/20} - 1)\}$,

$$1/Q_c = (C/f_{0n}) \times (\alpha_c/\pi \varepsilon_r^{1/2}), R_s = 0.0134 f_{0n}^{1/2},$$

$\alpha_c = \{4R_s Z_0 \varepsilon_r (b - t) / (120\pi)^2\}[1 + 2w/(b - t) + \{(b + t) / (\pi b - \pi t)\} \ln\{(2b - t)/t\}]$, and $R_s$ denotes skin resistance of the conductor.

As it is clear from above explanation, the dielectric constant of the dielectric body can be derived from the resonance frequency that is determined by the resonator 3 and the electrical correction length 4. Thus, values of the dielectric constant can be obtained only at resonance frequencies (f01 ~ fo4) as shown in Fig. 5, which means that it is impossible to obtain continuous values of the dielectric constant with frequency change, if the resonance method is deployed. Also it is impossible to make adjustment by changing the electrical correction length, because the resonator must have a symmetrical structure in this measurement method.

In the above equation for the dielectric loss, values of dielectric constant $\varepsilon_r$ and conductor skin resistance $R_s$ are unknown. While dielectric constant $\varepsilon_r$ can be obtained only as discrete values as described above, conductor skin resistance is actually difficult to obtain because it depends on the oxidization status of the conductor surface, on the shape of the conductor cross section, and also on the frequency.

As described above, the conventional resonance method to measure high frequency characteristics of dielectric materials has such problems as listed up below.

(1) The dielectric constant obtained by the resonance method is different from the effective dielectric constant of the dielectric material that is used for an actual circuit, because the measurement method must use the tri-plate microstrip line structure, instead of the one-sided microstrip line structure that is used for actual circuits.

In designing a high frequency circuit, it is desirable to know the effective dielectric constant of the dielectric material through which the electromagnetic wave actually propagates. By using the conventional measuring method, however, it is impossible to obtain the effective dielectric constant of the dielectric material at the same condition as it is implemented in actual circuits. Because of this difficulty in measurement, values of dielectric constant $\varepsilon_r$ written on usual catalogues for dielectric materials are mostly ones measured at about 1 MHz, not the ones measured in the frequency range for the actual design (1~10GHz, for example).

(2) The resonance frequency cannot be arbitrarily set for a tri-plate microstrip line resonator, because its structure is complicated. Consequently, by using the resonance method described above, dielectric constant can be obtained only at resonance frequencies, not at arbitrary frequencies.

(3) The above mentioned equations to derive the dielectric loss imply very complicated and indirect algorithms, which contain immeasurable deviations caused by the oxide film at the surface of the conductor or by the conductor structure. In other words, the equations are rather experimental ones without any considerations on effects by dielectric body itself, including the physical structure of it.

Also, there are several problems in the high frequency circuit design method that depends on the conventional measurement method. They are;

(1) In above mentioned approximation equations for high frequency circuits, the applicable value of dielectric constant $\varepsilon_r$ is obtained at about 1 MHz. This causes that the derived wavelength-shortening ratio may become considerably different from the actual one, if the designed frequency is in the region of several GHz.

(2) In above mentioned approximation equations for high frequency circuits, the electromagnetic field is analyzed by assuming that the dielectric body is uniform, and an experimental adjustment factor F is introduced. This method, however, does not reflect actual conditions of the dielectric body to be used.

If the wavelength of an electromagnetic wave propagating along the dielectric body can be measured at any arbitrary frequency, the effective dielectric constant of the microstrip line at that frequency can be obtained, since the effective dielectric constant is dependant on the frequency. This will enable accurate design of high frequency circuits for wireless communications equipment. Unfortunately, however, there have not been any effective means before to measure the wavelength of an electromagnetic wave which propagates on a microstrip line, at any arbitrary frequency especially in the microwave region, as mentioned above.

## SUMMARY OF THE INVENTION

This invention intends to solve such problems that are mentioned earlier. That is, the purpose of this invention is to provide with a method for continuous and accurate measurement of the effective dielectric constant and the dielectric loss of a dielectric material at the same condition as it is implemented in actual circuits. Thus the invention provides with a solution for already explained problems of the conventional resonance method in measuring high frequency characteristics of a dielectric material.

Another purpose of this invention is to improve the poor accuracy of the conventional high frequency circuit simulators, in order to realize high accuracy in high frequency circuit design. This purpose is realized by providing with a design method using the actual wavelength-shortening ratio of the circuit that is obtained through the measurement of circuit impedance at the same condition as the circuit is practically used.

The high frequency measurement method for dielectric materials of this invention is characterized as; it measures amplitude and phase variations of the electric field component of an electromagnetic wave along its propagation direction on a high frequency transmission line which is actually implemented as a microstrip line, by using a device whose refraction index changes according to the electric field (or an E-O prober using Pockels Effect), in order to get effective dielectric constant and dielectric loss of said transmission line.

The high frequency circuit design method of this invention is characterized as; phase variation rate of the electric field component of an electromagnetic wave along its propagation direction on a high frequency transmission line which is actually implemented as a microstrip line is measured by using a device whose refraction index changes according to the electric field (or an E-O prober using Pockels Effect), said phase variation rate is used to derive the wavelength-shortening ratio of said transmission line and said wavelength-shortening ratio is used in the high frequency circuit design.

Also the high frequency circuit design method of this invention is characterized as; in high frequency circuit design, phase variation rate of the electric field component of an electromagnetic wave along its propagation direction on a high frequency transmission line which is actually implemented as a microstrip line is measured by using a device whose refraction index changes according to the electric field (or an E-O prober using Pockels Effect), said phase variation rate is used to derive the wavelength-shortening ratio of said transmission line, a data table for the high frequency circuit design is generated using said wavelength-shortening ratio and said data table is used in the design.

## DESCRIPTION OF DRAWINGS

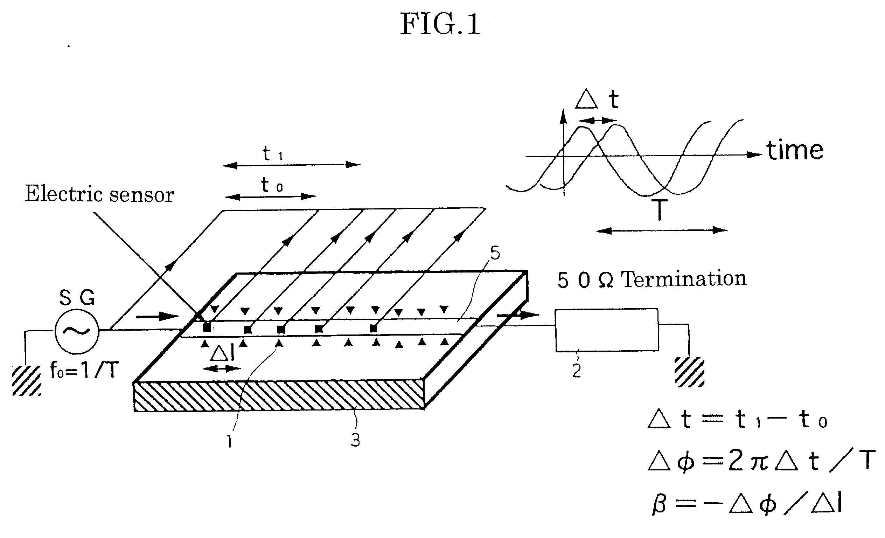

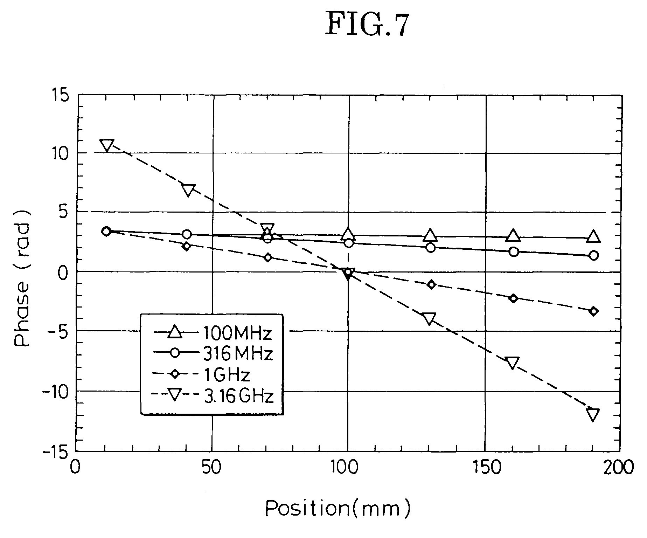

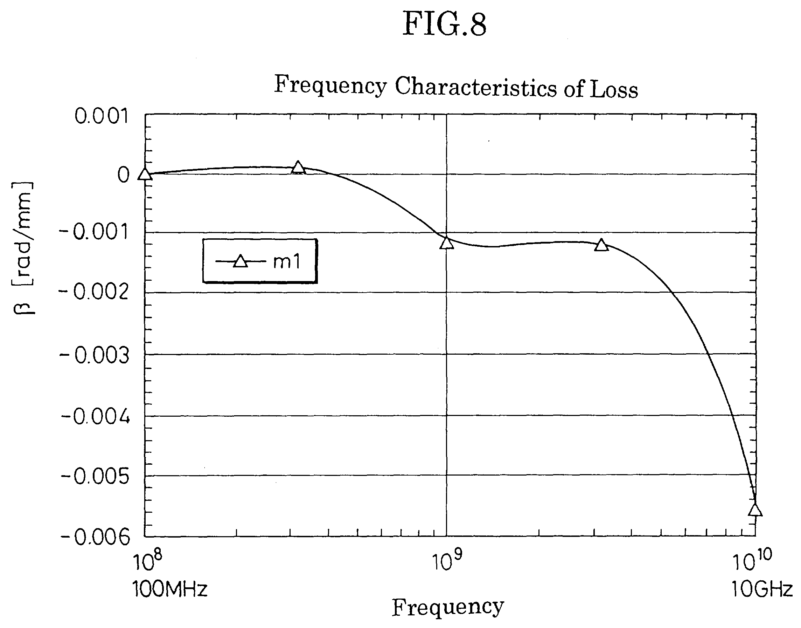

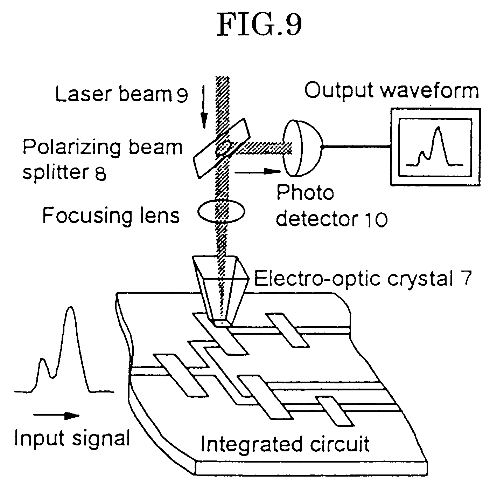

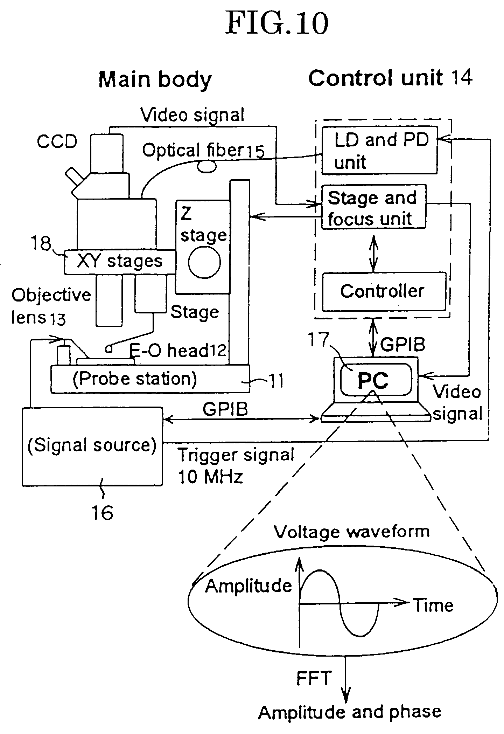

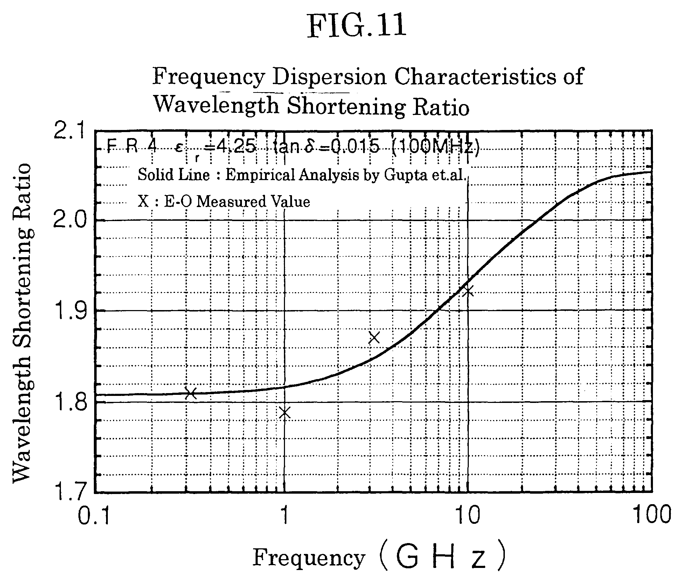

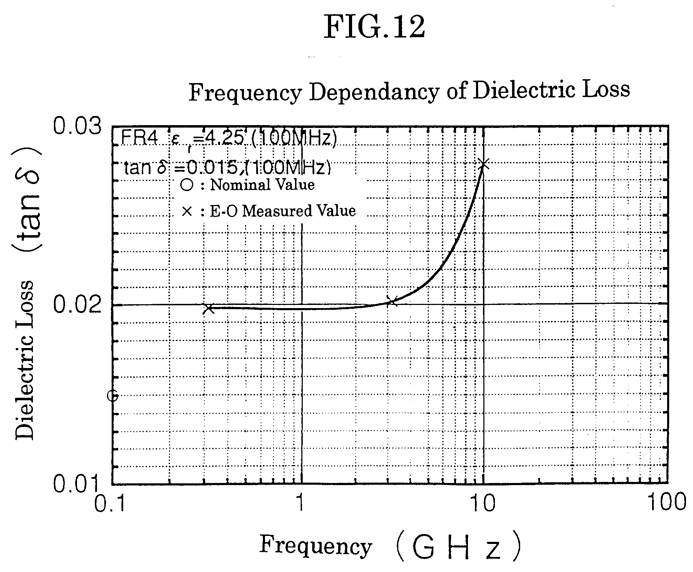

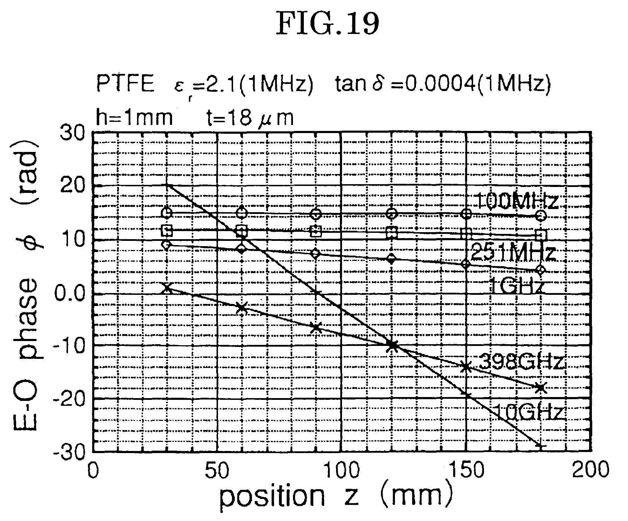

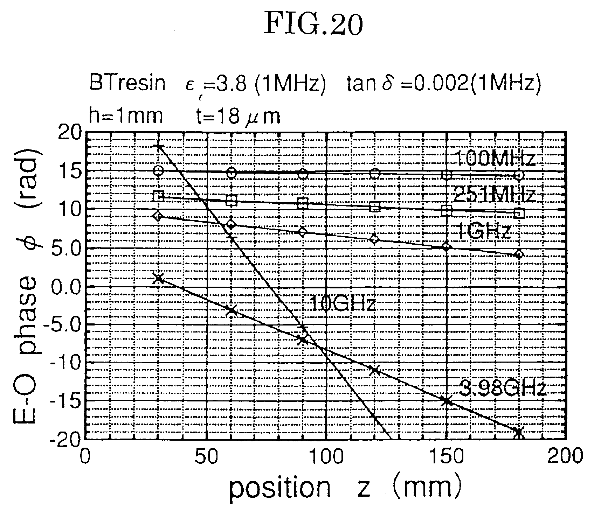

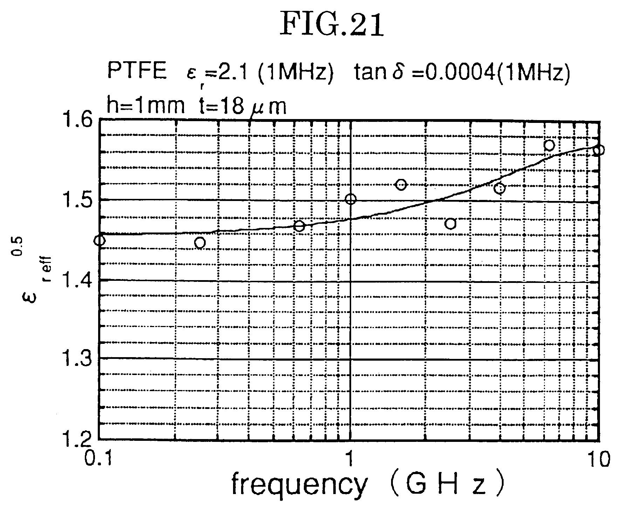

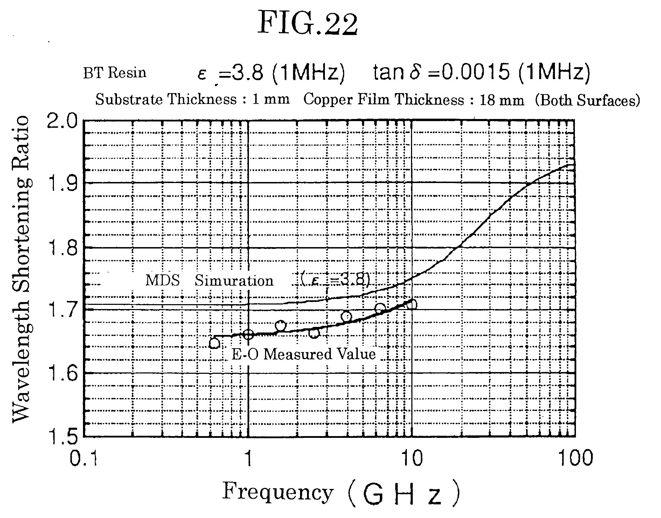

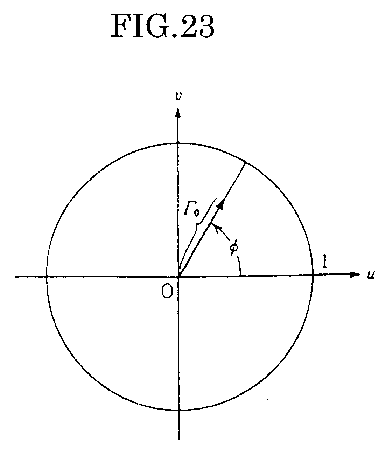

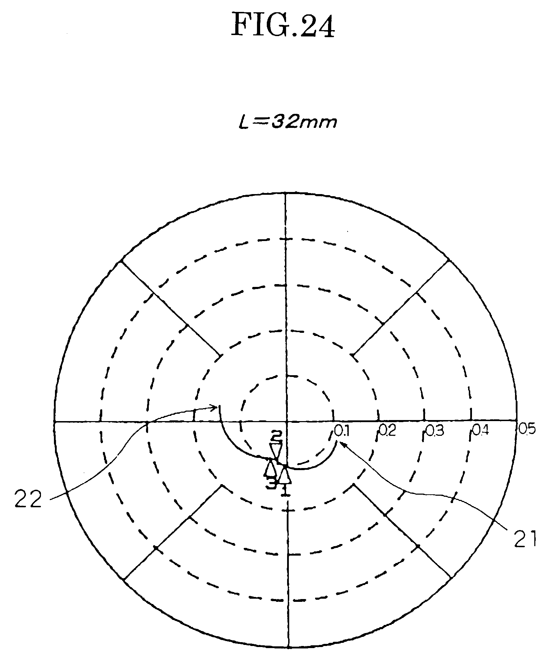

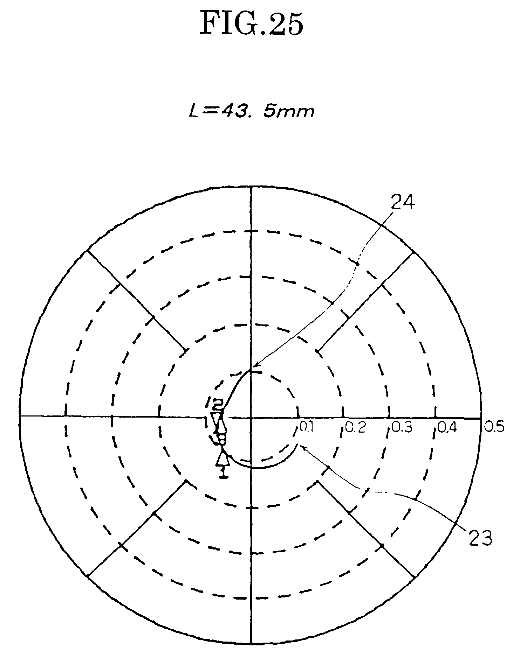

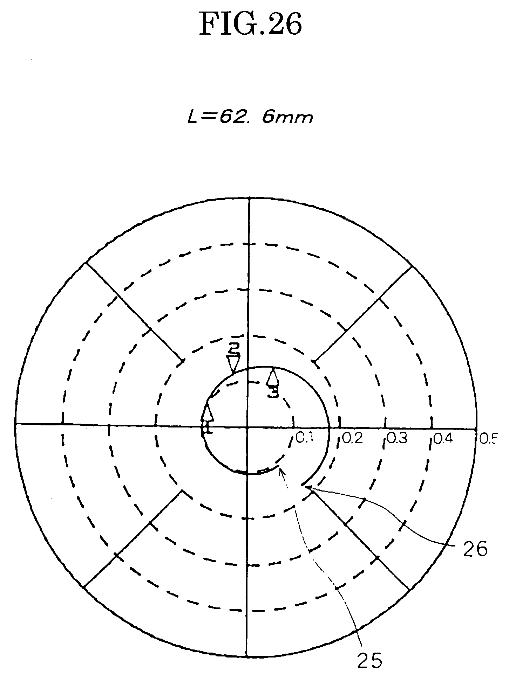

Figure 1 is a birds-eye view of a microstrip line which is used for the high frequency measurement employing the measurement method of this invention for effective dielectric constant (wavelength-shortening ratio) of a dielectric material. Figure 2 is a cross-section view of a microstrip line which is widely used for practical applications. Figure 3 is a cross-section view of a tri-plate structure microstrip line which is used for resonance method. Figure 4 is a plane figure of a tri-plate microstrip line. Figure 5 shows a measurement result example of high frequency characteristics by resonance method. Figure 6 shows a measurement result example of high frequency characteristics by resonance method. Figure 7 shows a measurement result example of high frequency characteristics of F4(glass epoxy resin) using the measurement method of this invention. **Figure 8** shows a measurement result example of high frequency characteristics of F4(glass epoxy resin) using the measurement method of this invention. **Figure 9** describes the measurement principle of the E-O prober. **Figure 10** shows the structure of the E-O prober. **Figure 11** is a graph of wavelength-shortening ratio obtained from the result of the measurement using the measurement method of this invention. **Figure 12** is a graph of wavelength-shortening ratio obtained from the result of the measurement using the measurement method of this invention. **Figure 13** shows a high frequency circuit design example using wavelength-shortening ratio obtained by this invention. **Figure 14** shows an impedance conversion formula for a microstrip line(distributed constant line). **Figure 15** depicts the structure of a microstrip line. **Figure 16** shows general characteristics of a microstrip line. **Figure 17** shows a low frequency waveform along a microstrip line cited from a reference. **Figure 18** shows a high frequency waveform along a microstrip line cited from a reference. **Figure 19** shows phase characteristics examples of a propagating signal voltage waveform for PTFE obtained by using the measurement method of this invention. **Figure 20** shows phase characteristics examples of a propagating signal voltage waveform for BT resin obtained by using the measurement method of this invention. **Figure 21** shows wavelength-shortening ratio examples of a propagating signal voltage waveform for PTFE obtained by using the measurement method of this invention. **Figure 22** shows wavelength-shortening ratio examples of a propagating signal voltage waveform for BT resin obtained by using the measurement method of this invention. **Figure 23** is a polar chart expression of a voltage reflection co-efficient. **Figure 24** is the polar chart expression of voltage reflection coefficient $\Gamma$ of a propagating signal voltage waveform when evaluation circuit length L is 32mm. **Figure 25** is the polar chart expression of voltage reflection co-efficient $\Gamma$ of a propagating signal voltage waveform when evaluation circuit length L is 43.5mm. **Figure 26** is the polar chart expression of voltage reflection coefficient $\Gamma$ of a propagating signal voltage waveform when evaluation circuit length L is 62.6mm.

## *DESCRIPTION OF THE PREFERRED EMBODIMENT*

The preferred embodiment of the invention will be explained hereinafter referring to drawings.

The electric field of an electromagnetic wave propagating along a transmission line(microstrip line) which is fabricated on a high frequency circuit substrate is expressed as follows by using wave number vector k;

$$E = E_0 \exp\{j(\omega t = kz)\}$$
$$= E_0 \exp(j\omega t) \exp\{ -j(\alpha - j\beta)z\} \qquad (1)$$
$$= E_0 \exp\{j(\omega t - \alpha z)\} \exp(-\beta z)$$

Here z denotes the position along the transmission line and $k = \alpha - j\beta$. The equation (1) shows that $\exp\{j(\omega t - \alpha z)\}$ is the phase component and $\exp(-\beta z)$ is the loss component. The following equation can be derived for the loss component.

$$10\log(P / P_0) = 20\log(E / E_0) = -20\beta z \log(e) \quad \therefore \quad \beta = -10\log(P/P_0)/\{-20\beta z \log(e)\} \qquad (2)$$

Also, the phase component can be written as;

$$\alpha = -d\phi / dz \qquad (3),$$

where $\phi$ is the phase value ($\omega t - kz$). When the position on the transmission line is given, values of $\alpha$ and $\beta$ can be obtained from measured values of the phase and the loss of the electric field at that position, by using equations (2) and (3). The effective dielectric constant and the dielectric loss of the dielectric material can be derived by using these of $\alpha$ and $\beta$, as explained in the following.

Generally, wavelength $\lambda$ of an electromagnetic wave propagating in a dielectric material becomes shorter than wavelength $\lambda_0$ in the vacuum. Namely,

$$\lambda = \lambda_0/\varepsilon_r^{1/2} \qquad (4).$$

Here $\varepsilon_r = \varepsilon / \varepsilon_0$ ($\varepsilon_r > 1$) ,is the effective dielectric constant of the dielectric material, and $\varepsilon_r^{1/2}$ is generally called as wavelength-shortening ratio.

The relationship between wave number vector k and the wavelength of an electromagnetic wave which propagates along a transmission line can be expressed as;

$$k = \alpha - j\beta = 2\pi/\lambda = 2\pi / (\lambda_0 / \varepsilon_{reff}^{1/2}) = 2\pi\varepsilon_{reff}^{1/2} / \lambda_0 \qquad (5).$$

Here, $\varepsilon_{reff}$ is the effective dielectric constant of the transmission line. Equation (4) is re-written by using $\varepsilon_{reff}$ as;

$$\lambda = \lambda_0 / \varepsilon_{reff}^{1/2} \tag{4}'$$

Since the upper half of the space above the transmission line is the free air when the transmission line is fabricated as a microstrip line, the effective dielectric constant of this transmission line becomes different from $\varepsilon_r$ which is the effective dielectric constant in the dielectric material. When the effective dielectric constant of the transmission line is put as $\varepsilon_{reff} = \varepsilon_{reff}' + j\,\varepsilon_{reff}''$, then the following equations hold.

$$\varepsilon_{reff}' = (\alpha^2 - \beta^2)\lambda_0^2 / (4\pi^2) \tag{6}$$

$$\varepsilon_{reff}'' = |\,\alpha\beta\lambda_0^2 / (2\pi^2)| \tag{7}$$

From (6) and (7), the dielectric loss is expressed as;

$$\tan\delta = \varepsilon_{reff}'' / \varepsilon_{reff}' = |2\alpha\beta / (\alpha^2 - \beta^2)| \tag{8}$$

In detail, equations (6) to (8) are derived as the following.

$$k = \alpha - j\beta = 2\pi\varepsilon_{reff}^{1/2} / \lambda_0 = 2\pi(\varepsilon_{reff}' + j\,\varepsilon_{reff}'')^{1/2} / \lambda_0$$
$$= (2\pi / \lambda_0)\,[\{\varepsilon_{reff}' + (\varepsilon_{reff}'^{\,2} + \varepsilon_{reff}''^{\,2})^{1/2}\} / 2]^{1/2}$$
$$+ j\,(2\pi / \lambda_0)\,(\varepsilon_{reff}'' / 2)\,[2 / \{\varepsilon_{reff}' + (\varepsilon_{reff}'^{\,2} + \varepsilon_{reff}''^{\,2})^{1/2}\}]^{1/2}$$

$$\therefore \quad \alpha = (2\pi / \lambda_0)\,[\{\varepsilon_{reff}' + (\varepsilon_{reff}'^{\,2} + \varepsilon_{reff}''^{\,2})^{1/2}\} / 2]^{1/2}$$
$$\beta = (2\pi / \lambda_0)\,(\varepsilon_{reff}'' / 2)\,[2 / \{\varepsilon_{reff}' + (\varepsilon_{reff}'^{\,2} + \varepsilon_{reff}''^{\,2})^{1/2}\}]^{1/2}$$
$$\therefore \quad \varepsilon_{reff}'' = (\alpha\beta / 2)(\lambda_0 / \pi)^2$$

$$\beta / \alpha = \frac{(2\pi / \lambda_0)\,(\varepsilon_{reff}'' / 2)\,[2 / \{\varepsilon_{reff}' + (\varepsilon_{reff}'^{\,2} + \varepsilon_{reff}''^{\,2})^{1/2}\}]^{1/2}}{(2\pi / \lambda_0)\,[\{\varepsilon_{reff}' + (\varepsilon_{reff}'^{\,2} + \varepsilon_{reff}''^{\,2})^{1/2}\} / 2]^{1/2}}$$
$$= \varepsilon_{reff}'' / \{\varepsilon_{reff}' + (\varepsilon_{reff}'^{\,2} + \varepsilon_{reff}''^{\,2})^{1/2}\}$$
$$= \tan\delta / \{1 + (1 + \tan^2\delta)^{1/2}\},$$
where $\tan\delta = \varepsilon_{reff}'' / \varepsilon_{reff}'$.

Figure 1 is a birds-eye view of a microstrip line which is used for the high frequency measurement employing the measurement method of this invention. The line 5 in the center of the substrate surface works as a transmission line. Points 1 which are shown by symbols ▼ in the figure denote the measuring points. These measuring points are placed along the propagation direction of the electromagnetic wave, at 5mm intervals from the edge of the transmission line 5. As said line 5 is terminated by the characteristic impedance of the line, 50Ω, only the electromagnetic wave that propagates in the direction to the right exists on the line.

Amplitude and phase variations of the electric field component of the electromagnetic wave along its propagation direction on the high frequency transmission line are measured at said measuring points 1, by touching a measuring element whose refraction index changes according to the electric field applied to it.

When seeing from another aspect, it is understood that measurement results using the above-mentioned measuring method can be utilized for more accurate design of high frequency circuits than using conventional technologies. That is, since the following equation holds in general,

$$\lambda = 2\pi / \beta \tag{9},$$

$\varepsilon_{reff}$ can be expressed as the following by using equations (4)' and (9).

$$\varepsilon_{reff}^{1/2} = \lambda_0 \beta / (2\pi) \tag{10}$$

It will be clear from above analysis that the wavelength-shortening ratio can be derived from equation (10), when the phase component in the electric field component of the electromagnetic wave propagating along the transmission is detected at position z. At this measurement, the precise value of $\beta$ can be obtained since $\beta$ is the gradient of phase $\phi$ in the direction of z and it does not include errors inherent to measurement instruments.

As explained above, the design method of this invention for high frequency circuits that uses an E-O prober is characterizes as; (a) it uses a measuring element whose refraction coefficient changes according to the electromagnetic field applied to it in order to measure the phase component variation ratio against the propagation direction of the electromagnetic wave which propagates along the transmission line, (b) it calculates the transmission wavelength of the transmission line from said phase component variation rate, (c) it derives the wavelength-shortening ratio of said transmission line from the ratio between said transmission wavelength and the wavelength in the vacuum, and (d) it composes an impedance conversion circuit by using the derived wavelength-shortening ratio. The precise value of the wavelength-shortening ratio can be obtained by using the measurement method of this invention, since measurement errors usually inherent to measuring instruments can be avoided because the phase value of the electric field component of the electromagnetic wave which propagates along the high frequency transmission line is directly measured, and because the variation rate of said measured phase value against the propagation direction is used for the design.

A conventional sensor used for the measurement described above, whose refraction coefficient changes according to the electromagnetic field applied to it, is explained next. This sensor is an ultra-high speed voltage waveform measuring equipment, or so-called E-O prober, which uses a non-contact electric field sensor. Examples of such a sensor are explained in detail in such references as "Highly Sensitive Real Time Electro-Optic Probing for Long Logic Pattern Analysis", Hironori Takahashi, Shin-ichiro Aoshima, Kazuhiko Wakamori, Isuke Hirano and Yutaka Tsuchiya, IEICE Trans. Electron, Vol. E78-C, No. 1, January 1995, pp67-72, "Sampling and Real-Time Methods in Electro-Optic Probing System", Hironori Takahashi, Shin-ichiro Aoshima and Yutaka Tsuchiya, IEEE Trans. on Instrumentation and Measurement, Vol. 44, No. 5, October 1995, pp965-971, "Femto-second fiber coupling E-O prober using dispersion pre-compensation and differential detection", H. Takahashi, K. Kuroyanagi, H. Shimonuma, K. Hikita and T. Yamanaka, Proceedings of International Topical Workshop on Contemporary Photonic Technologies(CPT '98), January 12-14, 1998, pp225-227, and "Ultrafast E-O Sampling using ZnTe Crystal and Ti:sapphire Laser", Hironori Takahashi, Kazuyoshi Kuroyanagi, Shin-ichiro Aoshima and Yutaka Tsuchiya, Proceedings of International Topical Meeting on Microwave Photonics, December 3-5, 1996, pp189-191.

The E-O prober is an ultra-high speed voltage waveform measuring equipment for the evaluation of a microwave circuit, consisting of a non-contact electric field sensor and a semiconductor pulse laser. The E-O prober can measure voltage waveforms inside a device such as an MMIC with high time-resolution and without touching the device nor disturbing the device status. This feature of the E-O prober, which has not been realized by conventional electric measuring methods, comes from its measurement principle shown in Fig. 9.

In Fig. 9, an electric field sensor 7 that is composed of an electro-optic crystal is placed near the electrode under measurement. The refraction index of the electric field sensor changes according to the applied voltage at said electrode. When a laser beam 9 is applied to the electric field sensor, the polarization status of the laser beam is changed according to the change in the refraction index of the crystal. This causes the intensity change of the optical output which is derived from the optical splitter 8. This optical output is detected by an optical detector 10, and then amplified by a lock-in amplifier or the like, to get an enough level of a voltage waveform.

Since the response time of the electro-optic crystal used in the electric field sensor is as fast as less than 1 psec., high time resolution as narrow as the laser pulse width can be obtained, if sampling measurement method using a pulsed laser beam is employed. In addition to this, transmission distortion caused by a transmission line does not exist in this measurement method, since the optical beam is used for measurement.

The electrical field sensor crystal is attached to a silica-glass holder which is fixed at the top of a metallic or ceramic needle. One side length of the sensor is about $200\mu m$. The electric field sensor detects the leaked electric field from the electrode, so that the sensor need not touch the electrode. Since the laser beam is reflected by the mirror surface of the electric field sensor bottom, it does not reach to the electrode. Thus the laser beam does not affect the behavior of the measured device. Although the electric field sensor works as a load for the electrode to be measured, its capacitance is very small. As a result it affects the electrode little, enabling the non-intrusive measurement. The measurable area of the electric field sensor is determined by the focused optical beam diameter, which allows measuring anywhere in an IC, as far as the sensor can access.

A device whose refraction index changes according to the electric field is not limited to the device using Pockels effect (refraction index changes in proportion to the electric field). A device using Kerr effect (refraction index changes in proportion to the square of the electric field) may be also used.

Figure 10 shows the structure of E-O prober equipment. The main body of the E-O prober is assembled on a probe station 11 for microwave devices, and is used as a microscope for observation. An E-O head 12, which is the electric field sensor, is set under an object lens 13, and is moved by a motor driven from an external controller. A semiconductor laser LD is contained in a control unit 14, and the laser light enters into or comes out from the main body through an optical fiber 15.

An output from the main oscillator 16 of a signal source, which is 10MHz for example, is fed to the control unit 16 and is used as a triggering signal, in order to synchronize the optical output to the device under measurement. The semiconductor laser lights synchronous to this triggering signal, at the frequency of 1 MHz, for example. The measuring operation is carried out on a personal computer 17. Watching a microscopic image on the personal computer monitor, measurement position is determined first by manipulating an XY stage 18 from outside. Then, after bringing the E-O head near to the electrode to be measured by using an auto-focusing function, measurement begins. Processed waveform data are displayed on the personal computer. Amplitude and phase information in the frequency domain can be derived by using Fast Fourier Transform (FFT). By using such a simple method as described above, a voltage waveform at any arbitrary point in an IC can be obtained, just as like as the measurement using a sampling oscilloscope.

Since the optical source semiconductor laser LD is synchronized to the signal source and the LD is connected to the electric field sensor through the optical fiber in above mentioned E-O prober, the timing of the measurement at the measuring point is kept constant even if the electric field sensor is moved on the device under measurement. Let us assume here that the device under measurement is a microstrip line, and that an impulse wave is applied to the transmission line. In a case where the voltage waveform is measured at different points along the transmission line by moving the E-O prober from the input end to the output end of the line, the waveform measured at the output end is time delayed as compared to the waveform measured at the input end. This delay, which is previously mentioned $\alpha$, depends on the propagation velocity of the voltage wave propagating on the transmission line. If the waveform attenuates because the electric resistance of the transmission line is large, the amplitude of the waveform at the output port becomes small, so that previously mentioned $\beta$ is measured.

As has been already described, the impedance of the electric field sensor in the E-O prober is so large that the sensor does not affect the behavior of the device under test. When the transmission line is fabricated on a substrate made from a dielectric material with a certain value of permittivity, the propagation velocity of the waveform on the transmission line depends mainly on the dielectric constant of the substrate. Also, the attenuation of the waveform depends on the loss tangent of the substrate. Thus, when the dielectric constant or the loss tangent of an unknown dielectric body is required, such values can be derived by fabricating a transmission line on the dielectric body, transmitting an electric signal on the transmission line, measuring the waveform at each point along the transmission line through the E-O prober and analyzing the measured results.

The double refraction coefficient of the E-O crystal is changed according to the electric field intensity, when the electric field on the transmission line is coupled to the E-O crystal as described above. If the pulsed laser light is injected to the E-O crystal at this condition, the polarization status of the laser light is changed, and thus the waveform of the signal under measurement can be observed. The spatial resolution, the frequency bandwidth and the measurement sensitivity of the E-O prober used here are 5$\mu$m, 20GHz and 50mV, respectively.

Figures 7, and 8 show measurement examples for a dielectric material. The high frequency circuit board material used in the experiment is FR4(glass epoxy material), with the substrate thickness of 1 mm, the conductor thickness of 18$\mu$m, the nominal dielectric constant at 100MHz, $\varepsilon_r = 4.25$ and the nominal dielectric loss at 100MHz, $\tan \delta = 0.015$.

The value of $\beta$ can be derived by using Equation (2) from the measured loss characteristic curve (Fig. 8) of the electric field at each measuring point. Also, The value of $\alpha$ can be derived from the electric field variation at each measuring point (the slope of each line in Fig. 7). Consequently, the effective dielectric constant and the dielectric loss can be calculated by applying values of $\alpha$ and $\beta$ derived as above to equations (6), (7) and (8).

Tables 1 and 2 show the experiment result and the calculation result. These results are illustrated as figures in Fig. 11 and Fig. 12, respectively. The wavelength-shortening ratio in Fig. 11 is the very important factor for circuit design, and the dielectric loss curve in Fig. 12 is also very important data for evaluating high frequency characteristics of a dielectric material. Although Fig. 11 shows similar data plots as the conventional empirical analysis curve, the analyzed values are merely supposed values based on empiricism. Additionally this analysis is complex and needs much calculation time. Considering all of these factors, and taking into consideration that the method is much simpler and the measurement results are much more accurate and reliable, it is evident that the measuring method of this invention is much superior to conventional methods.

Table 1

| Measuring Freq.[Hz] | 100MHz | 316MHz | 1GHz | 3.16GHz | 10GHz |
|---|---|---|---|---|---|
| $\alpha$ [rad/mm] | -0.0032778 | -0.011984 | -0.037462 | -0.12387 | -0.40379 |
| $\alpha$ [deg/mm] | -0.1879 | -0.6870 | -2.148 | -7.101 | -23.147 |
| $\lambda$ [mm] | 1915.9 | 524.0 | 167.6 | 50.7 | 15.6 |
| $\lambda_0$ [mm] | 2997.9 | 948.7 | 299.79 | 94.87 | 29.979 |
| $(\varepsilon_{eff})^{1/2}$ | 1.565 | 1.810 | 1.789 | 1.871 | 1.922 |

Table 2

| Measuring Freq.[Hz] | 100MHz | 316MHz | 1GHz | 3.16GHz | 10GHz |
|---|---|---|---|---|---|
| $\alpha$ [rad/mm] | -0.0032778 | -0.011984 | -0.037462 | -0.12387 | -0.40379 |
| $\beta$ [rad/mm] | -0.00001 | -0.0001186 | -0.0011891 | -0.0012458 | -0.0056371 |
| $(\varepsilon_{eff})^{1/2}$ derived from $\alpha$ | 1.565 | 1.810 | 1.789 | 1.871 | 1.922 |
| tan $\delta$ derived from $\alpha$ and $\beta$ | 0.0061 | 0.019787 | 0.06355 | 0.02017 | 0.02793 |

In addition to above, there are no effective conventional methods for measuring the dielectric loss shown in Fig. 12. The circle in Fig. 12 shows the nominal dielectric loss of the dielectric material used in the measurement. As previously mentioned, it is not the value at a high frequency, especially at 1GHz or higher, but the one at a low frequency. This is only because there are no conventional ways to measure dielectric loss in the high frequency region, so that the value at the lower frequency is substituted. However, as Fig. 12 shows, the dielectric loss characteristics in the high frequency region are clearly different from those in the low frequency region.

As explained above, the measurement method of this invention provides with; (1) a continuous measurement method up to about 10GHz for effective permittivity and dielectric loss of a dielectric body implemented as an actual circuit, instead of using approximated values for them based on empirical formulae, and (2) a method to derive effective dielectric constant of a dielectric body at the same condition as it is used for a common microstrip line structure, without using any complicated structures as a tri-plate microstrip line which is necessary for the conventional resonance measurement method.

In the tri-plate microstrip line structure mentioned above, there exist many causes of errors in measured values, such as pattern size inaccuracy of the transmission line or increase in resistance of the transmission line by the surface oxide film or by rusting. Therefore, the conventional measurement method using this structure is not accurate enough for deriving the dielectric loss, resulting in a big difference between the derived value and the actual value for the microstrip line. On the contrary, the measurement method of this invention is not affected by such error causes, so that the accurate effective dielectric constant and the dielectric loss can be derived at the same condition as the transmission line is practically used for signal transmission.

Application examples of this invention to high frequency circuit substrates using PTFE and BT resin are explained hereinafter. Here PTFE is the abbreviation of Poly-Tetra-Fluoro-Ethylene (Teflon as the product name), and BT is the abbreviation of Bismaray-imido-Triasin. Also, BT resin is the product name of glass-degenerated BT substrates by Mitsubishi Gas and Chemical Co. Ltd.. Material characteristics of PTFE and BT resin are illustrated in Table 3.

Table 3

| | PTFE | BT Resin |
|---|---|---|
| • Dielectric Constant | 2.1 (1 MHz) | 3.8 (1 MHz) |
| • Dielectric Loss | 0.0004 (1 MHz) | 0.002 (1 MHz) |

Table 3 (continued)

|  | PTFE | BT Resin |
|---|---|---|
| • Substrate Thickness | 1 mm | 1 mm |
| • Conductor Thickness | 18μm (Electrolytic Cu) | 18 μm (Electrolytic Cu) |

As already explained, Fig. 1 shows a microstrip line which is used for the embodiment of the invention. The line running in the center of the substrate is the transmission line. Each point 1 shown by symbol ▼ is the measuring point. Figures 19 and 20 show phase variations of the voltage waveform measured at each measuring point. The value of $\alpha$ can be derived as the gradient of curves in Fig. 19 and Fig. 20. From this $\alpha$, the transmission wavelength $\lambda$ (the length corresponding to $2\pi$ radian is equal to the wavelength) can be derived. Then, the wavelength- shortening ratio is calculated from this $\lambda$ and the designed frequency. Transmission wavelengths and effective dielectric constants derived by using said E-O prober measuring method are listed in Table 4 and Table 5, respectively. Figures 21 and 22 depict the frequency dependency of the wavelength-shortening ratio. The wavelength-shortening ratio of BT resin at 1GHz is calculated as 1.66 by using this measuring method, whereas the one derived by the high frequency simulator is 1.71.

Table 4

|  | PTFE | | BT Resin | |
|---|---|---|---|---|
| Frequency | $\beta$ (rad/mm) | $\lambda$ (mm) | $\beta$ (rad/mm) | $\lambda$ (mm) |
| 100 MHz | 0.00304 | 2066.84 | 0.00348 | 1806.5 |
| 251 MHz | 0.00768 | 818.12 | 0.0084 | 749.97 |
| 1 GHz | 0.0314 | 200.10 | 0.0328 | 191.88 |
| 3.98 GHz | 0.1266 | 49.63 | 0.1326 | 47.38 |
| 10 GHz | 0.3281 | 19.15 | 0.3920 | 16.03 |

Table 5

|  |  | PTFE | | BT Resin | |
|---|---|---|---|---|---|
| Frequency | $\lambda_0$(mm) | $\lambda$ (mm) | $\varepsilon_{reff}$ | $\lambda$ (mm) | $\varepsilon_{reff}$ |
| 100MHz | 2997.9 | 2066.84 | 2.10 | 1806.5 | 2.754 |
| 251MHz | 1194.4 | 818.12 | 2.13 | 749.97 | 2.536 |
| 1GHz | 299.79 | 200.10 | 2.24 | 191.88 | 2.441 |
| 3.98 GHz | 75.324 | 49.63 | 2.303 | 47.38 | 2.527 |
| 10 GHz | 29.979 | 19.15 | 2.451 | 16.03 | 3.498 |

Evaluation experiment for the values of wavelength-shortening ratio was carried out by using a microstrip line shown in Fig. 13. The evaluation circuit is made of three portions as shown in the figure, one is having the characteristic impedance of 63Ω and the length of 18.1 mm, and the other two are having the characteristic impedance of 52.4Ω and are respectively placed at the both sides of the first portion. The total length of the line is 100mm. In Fig. 13, a high frequency signal is applied to the terminal at the left side of the transmission line of the evaluation circuit through a connector, and the terminal at the right side is terminated by 50Ω through another connector. No reflections occur by virtue of this termination, so that there exists only forward propagating wave on the transmission line. The symbol L in the figure shows an experimental parameter, and its values were set to 32mm, 43.5mm and 62.6mm in the experiment. The evaluation experiment procedure is as follows.

In designing a high frequency circuit, it is required to determine arbitrarily the load impedance at an arbitrary frequency. In order to verify the effectiveness of the design method of this invention, it is necessary to design an evaluation circuit as shown in Fig. 13, considering the phase shift at the connectors (the actual circuit consideration). In this verification, relative phase differences between different samples are examined in order to eliminate such influence by connectors.

The load of a transmission line can be generally expressed in terms of voltage reflection coefficient $\Gamma$, where $\Gamma$ (= u + j v) is plotted on a polar chart. In the following explanation, mag $\Gamma$ means $\Gamma_0$ in Fig.23, and $\angle \Gamma$ means $\phi$ in Fig.23. Measured values of the impedance for L = 43.5mm and L = 62.6mm in the following explanation are calculated in comparison with the reference value measured for L = 32mm, in order to avoid the influence by terminator 2 in Fig. 1. These lengths for L are values which are temporarily designed based on the data obtained by the E-O prober.

Figures 24 to 26 show frequency characteristics of measured values of $\Gamma$ in the evaluation circuit for L = 32mm, L = 43.5mm and L = 62.6mm, respectively, using polar displays as same as shown in Fig. 23. For example, point 21 in Fig.24 shows the value of $\Gamma$ at 0.5GHz and point 22 is the value of $\Gamma$ at 1.5GHz. Also △1, ▽2 and △3 in the figure show the values of $\Gamma$ at interim frequencies 0.9GHz, 1.0GHz and 1.1GHz, respectively. Similarly, in Fig. 25 and Fig. 26, points 23 and 25 show the values of $\Gamma$ at 0.5GHz, and points 24 and 26 show the values of $\Gamma$ at 1.5GHz. The following values are based on the measurement values at point ▽2, namely, at 1GHz.

Measured values of reflection coefficient $\Gamma$ are obtained as the following.

$$L = 32mm \ (\delta = 49.9mm) \qquad \text{[Sample 1]}$$

$$mag \ \Gamma = 0.092068$$

$$\angle \ \Gamma = -104.69°$$

$$\therefore \ \Gamma = (47\Omega - j8.4\Omega)$$

$$L = 43.5mm \ (\delta = 38.4mm) \qquad \text{[Sample 2]}$$

$$mag \ \Gamma = 0.078423$$

$$\angle\Gamma = - 158.41°$$

$$L = 62.6mm \ (\delta = 19.3mm) \qquad \text{[Sample 3]}$$

$$mag \ \Gamma = 0.11885$$

$$\angle\Gamma = -105.23°$$

By comparing the values for sample 1 and sample 2, design parameter values can be derived as;

$$l = 49.9mm - 38.4mm = 11.5mm,$$

$$\therefore \ \beta l = 1.99° \ /mm \ x \ 11.5 \ mm = 22.9° \ ,$$

where the value (1.99° /mm) means the phase variation per unit length of the line with the characteristic impedance of 52.4$\Omega$ at the left hand side in Fig. 13, and $\beta l$ shows the total phase variation increase of the sample 2 caused by the 52.4$\Omega$ line length increase as compared to the sample 1.

Accordingly, input impedance Z of sample 2 is;

$$Z = Z_0 \ (Z_L + j \ Z_0 \tan \beta l)/(Z_0 + j \ Z_L \tan \beta l)$$
$$= 52.4\Omega \ \{(47\Omega - j8.4\Omega) + j52.4\Omega \tan 22.9° \ \}/ \ \{52.4\Omega + j(47\Omega - j8.4\Omega) \tan 22.9° \ \}$$
$$= 43.2\Omega - j2.38\Omega,$$

$$\therefore \ \Gamma = 0.077 \ \angle -159.23° \ .$$

It is clear that this value is very close to the measured value of $\Gamma$, 0.07843 $\angle$ - 158.41° .

By comparing sample 1 and sample 2, just similarly as above,

$$l = 49.9mm - 19.3mm = 30.6mm,$$

$$\therefore \beta l = 1.99° \text{ /mm x } 30.6\text{mm} = 60.9° ,$$

Accordingly, input impedance Z of sample 3 is;

$$Z = Z_0 (Z_L + j Z_0 \tan \beta l) / (Z_0 + j Z_L \tan \beta l)$$
$$= 52.4\Omega \{(47\Omega - j8.4\Omega) + j52.4\Omega \tan 60.9° \} / \{52.4\Omega + j(47\Omega - j8.4\Omega) \tan 60.9° \}$$
$$= 46.93\Omega - j8.21\Omega,$$

$$\therefore \Gamma = 0.090 \angle -105.632°.$$

It is also clear that this value is very close to the measured value of $\Gamma$, 0.11885 $\angle$ - 105.23° .

As explained previously, a precise measurement method for high frequency characteristics, especially for the effective dielectric constant, of the dielectric material is important in developing, designing and estimating a circuit board for a high frequency circuit, since the impedance of a microstrip line is determined by the effective dielectric constant and the line length. The measurement method of this invention provides with such a precise measurement method for high frequency characteristics of the dielectric material, leading to its significant effectiveness such that;

(1) it provides with a continuous measurement method up to about 10GHz for effective permittivity and dielectric loss of a dielectric body implemented as an actual circuit, instead of using approximated values for them based on empirical formulae. Consequently, it becomes possible to measure continuously up to about 10GHz the wavelength-shortening ratio of a dielectric body implemented as an actual circuit, without using a conventional high frequency circuit design simulator which uses the effective permittivity at about 1MHz, and

(2) it provides with a method to derive effective dielectric constant of a dielectric body at the same condition as it is used for a common microstrip line structure, without using any complicated structures as a tri-plate microstrip line which is necessary for the conventional resonance measurement method. Consequently, by using the high frequency circuit design method of this invention, the circuit design accuracy can be increased by far as compared to the conventional method. Additionally, the number of trial fabrication for the high frequency circuit can be reduced to only a few times, as compared to the conventional cut and try method. Increase in repeatability is also realized.

The purpose of this invention is to provide with a method for continuous and accurate measurement of the effective dielectric constant and the dielectric loss of a dielectric material at the same condition as it is implemented in actual circuits. Another purpose of this invention is to improve the high frequency circuit design accuracy by providing with a design method using the actual wavelength-shortening ratio of the circuit that is obtained through the measurement of circuit impedance at the same condition as the circuit is practically used.

The high frequency measurement method for dielectric materials of this invention is characterized as; it measures amplitude and phase variations of the electric field component of an electromagnetic wave along its propagation direction on a high frequency transmission line which is actually implemented as a microstrip line, by using a device whose refraction index changes according to the electric field (or an E-O prober using Pockels Effect), in order to get effective dielectric constant and dielectric loss of said transmission line.

The high frequency circuit design method of this invention is characterized as; phase variation rate of the electric field component of an electromagnetic wave along its propagation direction on a high frequency transmission line which is actually implemented as a microstrip line is measured by using a device whose refraction index changes according to the electric field (or an E-O prober using Pockels Effect), said phase variation rate is used to derive the wavelength-shortening ratio of said transmission line and said wavelength-shortening ratio is used for the high frequency circuit design.

## Claims

1.  A high frequency characteristics measurement method for dielectric materials which is characterized as; it measures amplitude and phase variations of the electric field component of an electromagnetic wave along its propagation direction on a high frequency transmission line, by using a device whose refraction index changes according to the electric field, in order to get effective dielectric constant and dielectric loss of said transmission line.

2.  A high frequency characteristics measurement method for dielectric materials as claimed in claim 1 where said transmission line is actually implemented as a microstrip line.

3. A high frequency characteristics measurement method for dielectric materials as claimed in claim 1 or in claim 2 where said device whose refraction index changes according to the electric field is an E-O prober using Pockels Effect.

4. A high frequency circuit design method which is characterized as; phase variation rate of the electric field component of an electromagnetic wave along its propagation direction on a high frequency transmission line is measured by using a device whose refraction index changes according to the electric field, said phase variation rate is used to derive the wavelength-shortening ratio of said transmission line and said wavelength-shortening ratio is used for the high frequency circuit design.

5. A high frequency circuit design method which is characterized as; phase variation rate of the electric field component of an electromagnetic wave along its propagation direction on a high frequency transmission line is measured by using a device whose refraction index changes according to the electric field, said phase variation rate is used to derive the wavelength-shortening ratio of said transmission line, a data table for the high frequency circuit design is created by using said wavelength-shortening ratio and said table is used for the high frequency circuit design.

6. A high frequency circuit design method as claimed in claim 4 or in claim 5 where said transmission line is actually implemented as a microstrip line.

7. A high frequency circuit design method as claimed in claim 4, in claim 5 or in claim 6 where said device whose refraction index changes according to the electric field is an E-O prober using Pockels Effect.

# FIG.1

EP 0 921 404 A2

$$\triangle t = t_1 - t_0$$
$$\triangle \phi = 2\pi \triangle t / T$$
$$\beta = -\triangle \phi / \triangle l$$

# FIG.2

Strip Conductor

Dielectric Substrate

w

$l$

b

$\varepsilon$

Ground Conductor

# FIG.3

# FIG.4

(2)      (1)

Input            Output

W

$\Delta L$      L      $\Delta L$

(3)

(4)

# FIG.5

# FIG.6

FIG.7

# FIG.8

## Frequency Characteristics of Loss

EP 0 921 404 A2

# FIG.9

Laser beam 9

Output waveform

Polarizing beam
splitter 8

Focusing lens

Photo
detector 10

Electro-optic crystal 7

Input signal

Integrated circuit

# FIG.10

**Main body**        **Control unit** 14

Video signal

CCD        Optical fiber 15

LD and PD unit

Stage and focus unit

Z stage

18
XY stages

Controller

Objective lens 13        Stage

17    GPIB

E-O head 12

(Probe station)        11

PC    Video signal

GPIB

(Signal source)    Trigger signal 10 MHz

16

Voltage waveform

Amplitude        Time

FFT

Amplitude and phase

# FIG.11

### Frequency Dispersion Characteristics of Wavelength Shortening Ratio

F R 4 $\varepsilon_r$ =4.25 $\tan\delta$ =0.015 (100MHz)
Solid Line : Empirical Analysis by Gupta et.al.
X : E-O Measured Value

Wavelength Shortening Ratio

Frequency ( G H z )

EP 0 921 404 A2

# FIG.12

## Frequency Dependancy of Dielectric Loss

EP 0 921 404 A2

# FIG.13

100mm

$L$        18. 1mm        $\delta$

40mm

Characteristic Impedance 52.4 Ω        Characteristic Impedance 63 Ω

50 Ω

*L=32mm, 43. 5mm, 62. 6mm*

# FIG.14

$$Z_{in} = Z_0 \frac{Z_L + j \, Z_0 \tan \beta l}{Z_0 + j \, Z_L \tan \beta l}$$

$$\beta = \frac{2 \pi \, \varepsilon_{reff}^{0.5}}{\lambda_0}$$

$l$

$Z_{in}$    $Z_0$    $\beta$

$Z_L$

# FIG.15

# FIG.16

# FIG.17

# FIG.18

# FIG.19

PTFE $\varepsilon_r$=2.1(1MHz)   tan $\delta$ =0.0004(1MHz)
h=1mm   t=18 $\mu$m

# FIG.20

BTresin $\varepsilon_r$=3.8 (1MHz) tan $\delta$ =0.002(1MHz)
h=1mm t=18 $\mu$m

# FIG.21

PTFE  $\varepsilon_r$=2.1 (1MHz)   tan $\delta$ =0.0004(1MHz)
h=1mm  t=18 $\mu$ m

# FIG.22

BT Resin       $\varepsilon$ =3.8 (1MHz)    tan $\delta$ =0.0015 (1MHz)

Substrate Thickness : 1 mm   Copper Film Thickness : 18 mm  (Both Surfaces)

# FIG.23

# FIG.24

$L=32mm$

# FIG.25

*L=43. 5mm*

# FIG.26

*L=62. 6mm*